(19) **Europäisches Patentamt / European Patent Office / Office européen des brevets**

(11) **EP 4 759 975 A1**

(12) **EUROPEAN PATENT APPLICATION**
published in accordance with Art. 153(4) EPC

(43) Date of publication:
17.06.2026 Bulletin 2026/25

(21) Application number: 24851880.5

(22) Date of filing: 07.08.2024

(51) International Patent Classification (IPC):
$C30B\ 29/38^{(2006.01)}$     $C23C\ 16/34^{(2006.01)}$
$C30B\ 25/20^{(2006.01)}$     $H01L\ 21/205^{(2006.01)}$

(52) Cooperative Patent Classification (CPC):
C23C 16/34; C30B 25/20; C30B 29/38; H10P 14/29

(86) International application number:
PCT/JP2024/028245

(87) International publication number:
WO 2025/033459 (13.02.2025 Gazette 2025/07)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 09.08.2023 JP 2023130116

(71) Applicants:
• Mitsubishi Chemical Corporation
Tokyo 100-8251 (JP)

• National Institute for Materials Science
Tsukuba-shi, Ibaraki 305-0047 (JP)

(72) Inventors:
• ODANI Takafumi
Tokyo 100-8251 (JP)
• OSHIMA Yuichi
Tsukuba-shi, Ibaraki 305-0047 (JP)

(74) Representative: Hoffmann Eitle
Patent- und Rechtsanwälte PartmbB
Arabellastraße 30
81925 München (DE)

(54) **GAN CRYSTAL AND METHOD FOR PRODUCING GAN CRYSTAL**

(57) The present invention relates to a GaN crystal including a Ni-doped GaN layer. The Ni-doped GaN layer has a Ni concentration of $1.0 \times 10^{16}$ atoms/cm³ or more and $1.0 \times 10^{20}$ atoms/cm³ or less. The Ni-doped GaN layer satisfies at least one of: (1) a total donor impurity concentration is less than $2.0 \times 10^{17}$ atoms/cm³; or (2) the full width at half maximum of a rocking curve by (004) X-ray diffraction is 50 arcsec or less.

FIG. 7

EP 4 759 975 A1

## Description

Technical Field

The present invention relates to a gallium nitride (GaN) crystal and a method for producing the GaN crystal.

Background Art

In recent years, GaN-based high electron mobility transistors (HEMTs) (which may hereinafter be referred to as "GaN-HEMTs") have been actively developed for use in devices for high frequencies of several tens of GHz to several hundreds of GHz.

The GaN-HEMT is formed by growing a GaN crystal on a substrate. As a substrate used for the GaN-HEMT, silicon, silicon carbide (SiC), GaN, and the like are being studied, but the GaN-HEMT using the GaN substrate is expected to have excellent performance compared with those using other substrates.

The GaN-HEMT repeats ON/OFF of a current at a high frequency, and ideally, it is required that no current flow at all in the OFF state. Thus, GaN substrates used for GaN-HEMTs are required to have high resistance, and such substrates are semi-insulated and formed into semi-insulating substrates (SI substrates).

A known method for semi-insulating the GaN substrate includes a method of doping a GaN crystal with a transition metal element. The transition metal element acts as an acceptor and thus has an effect of compensating for a background donor unintentionally introduced into the GaN substrate and reducing the carrier concentration in the GaN crystal. Such a transition metal element is referred to as a compensating impurity.

For example, in the invention described in Non-Patent Literature 1, a GaN crystal doped with iron (Fe) or manganese (Mn) as a compensating impurity is produced.

Citation List

Non-Patent Literature

Non-Patent Literature 1: M Iwinska et al., 'Iron and manganese as dopants used in the crystallization of highly resistive HVPE-GaN on native seeds', Japanese Journal of Applied Physics, vol. 58 SC1047, 2019

Summary of Invention

Technical Problem

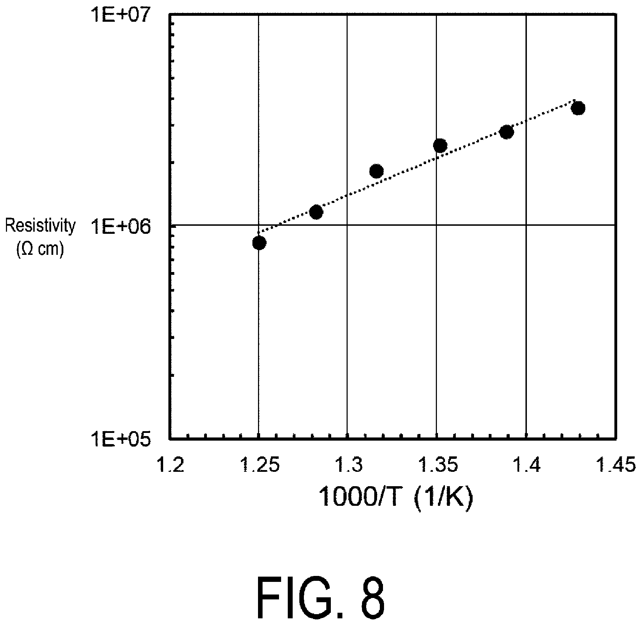

The resistivity of the SI substrate has been discussed as a value at or near room temperature in the art, but the resistivity is known to decrease as the temperature increases. Non-Patent Literature 1 also describes that the resistivity of the Mn-doped GaN crystal decreases as the temperature increases (see FIG. 8(a)).

In contrast to this, the application fields of high-frequency devices have been expanding in recent years, and along with that, the chances of using high-frequency devices in harsh regions, such as high-temperature environments, have also increased. Thus, the realization of high-frequency devices that can withstand high-temperature environments is one of the important issues for improving operational reliability in a wide range of application environments and for improving a large amount of information processing and controllability.

Thus, an object of the present invention is to provide a GaN crystal having high resistivity even in high-temperature environments.

Solution to Problem

The present inventors have diligently studied the above issue.

The present inventors have found that the resistivity can be increased by forming a GaN crystal including a Ni-doped GaN layer doped so that the Ni concentration is within a specific range, and furthermore, that better results can be obtained by adjusting the total donor impurity concentration in the Ni-doped GaN layer and the full width at half maximum of a rocking curve of the (004) plane within specific ranges, and that the above issue can be solved, thereby completing the present invention.

That is, the gist of the present invention is as follows.

[1] A GaN crystal containing a Ni-doped GaN layer, in which
the Ni-doped GaN layer has a Ni concentration of $1.0 \times 10^{16}$ atoms/cm$^3$ or more and $1.0 \times 10^{2°}$ atoms/cm$^3$ or less, and

satisfies at least one of requirements (1) and (2) below:

(1) the Ni-doped GaN layer has a total donor impurity concentration of less than $2.0 \times 10^{17}$ atoms/cm$^3$; and
(2) the full width at half maximum of a rocking curve of the Ni-doped GaN layer by (004) X-ray diffraction is 50 arcsec or less.

[2] The GaN crystal according to [1], in which the Ni-doped GaN layer has a dislocation density of less than $1 \times 10^7$ cm$^{-2}$.

[3] The GaN crystal according to [1] or [2], in which an activation energy Ea of resistivity of the Ni-doped GaN layer is 0.5 eV or more, the activation energy Ea obtained by substituting the resistivity into Equation (I):

$$\text{Resistivity } (\Omega \text{ cm}) = A \times \text{EXP}(-Ea/kT) \text{ (I)}$$

where

A is a proportionality constant,
EXP is an exponential function,
Ea is the activation energy (eV) of resistivity,
k is the Boltzmann constant ($8.617 \times 10^{-5}$ eV/K), and
T is temperature (K) in Kelvin.

[4] The GaN crystal according to [3], in which the activation energy Ea of resistivity is from 0.7 to 1.2 eV.

[5] The GaN crystal according to [3] or [4], in which

the activation energy Ea of resistivity is determined by a least squares method using the resistivity at two or more temperatures, and
a coefficient of determination $R^2$ of an approximation curve when exponential approximation is performed by the least squares method is 0.85 or more.

[6] The GaN crystal according to any one of [3] to [5], in which the activation energy Ea of resistivity is a value obtained by the least squares method by substituting the resistivity measured at 20 K intervals in a temperature range of 700 K to 800 K into Equation (I).

[7] The GaN crystal according to any one of [1] to [6], in which both an oxygen (O) concentration and a silicon (Si) concentration in the Ni-doped GaN layer are $1.0 \times 10^{15}$ atoms/cm$^3$ or more.

[8] The GaN crystal according to any one of [1] to [7], in which the resistivity of the Ni-doped GaN layer at 700 K is $5 \times 10^5$ $\Omega$ cm or more.

[9] The GaN crystal according to any one of [1] to [8], in which the resistivity of the Ni-doped GaN layer at 800 K is $5 \times 10^4$ $\Omega$ cm or more.

[10] The GaN crystal according to any one of [1] to [9], in which the Ni-doped GaN layer has a thickness of 50 $\mu$m or more.

[11] The GaN crystal according to any one of [1] to [10], in which the Ni-doped GaN layer has a surface inclined at 10 degrees or less from the (0001) crystal plane.

[12] A method for producing a GaN crystal including a Ni-doped GaN layer with a Ni concentration of $1.0 \times 10^{16}$ atoms/cm$^3$ or more and $1.0 \times 10^{20}$ atoms/cm$^3$ or less by a vapor phase epitaxy method, the method including: growing the Ni-doped GaN layer using nickel dichloride as a doping precursor.

[13] The method for producing a GaN crystal according to [12], in which the vapor phase epitaxy method is an HVPE method.

Advantageous Effects of Invention

According to the present invention, there is provided a GaN crystal that can maintain high resistivity even in high-temperature environments. Thus, the GaN crystal is very suitable as a substrate used for a nitride semiconductor device with a lateral device structure, such as a GaN-HEMT.

Brief Description of Drawings

FIG. 1 is a plan view illustrating a (0001) surface of a GaN crystal according to the present embodiment, the surface divided into 5 mm $\times$ 5 mm cells by a square grid.

FIG. 2 is a cross-sectional view illustrating one aspect of a GaN crystal according to the present embodiment.

FIG. 3 is a cross-sectional view illustrating one aspect of a GaN crystal according to the present embodiment.

FIG. 4 is a series of process cross-sectional views for explaining a method for producing a GaN crystal according to the present embodiment, in which FIG. 4(a) illustrates a state of a c-plane GaN seed, FIG. 4(b) illustrates a state in which a GaN layer is laminated on the c-plane GaN seed, and FIG. 4(c) illustrates a state in which the GaN layer having a laminated structure is thinned.

FIG. 5 is a series of process cross-sectional views for explaining a method for producing a c-plane GaN seed used for producing a GaN crystal according to the present embodiment, in which FIG. 5(a) illustrates a state of a seed wafer, FIG. 5(b) illustrates a state in which a GaN pressure film has grown on the c-plane GaN seed, and FIG. 5(c) illustrates a state in which at least one c-plane GaN seed is produced by processing a GaN thick film.

FIG. 6 is a schematic view illustrating a basic configuration of an HVPE apparatus.

FIG. 7 is a graph showing measurement results of resistivity in a GaN crystal of Example 1.

FIG. 8 is a graph showing measurement results of resistivity in a GaN crystal of Example 2.

Description of Embodiments

The present invention will be described in detail below, but the present invention is not limited to the following embodiments and can be carried out with various modifications within the scope of the gist of the invention.

In the present specification, a crystal axis parallel to the [0001] axis is referred to as a c-axis, a crystal axis parallel to the <10-10> axis as an m-axis, and a crystal axis parallel to the <11-20> axis as an a-axis. A crystal plane perpendicular to the c-axis is referred to as a c-plane, a crystal plane perpendicular to the m-axis as an m-plane, and a crystal plane perpendicular to the a-axis as an a-plane.

The Miller index (hkil) of a hexagonal crystal has a relationship of h + k = -i and thus may be represented by three digits as (hkl). For example, a three-digit representation of (0004) is (004).

In the present specification, a mention of a crystal axis, a crystal plane, a crystal orientation, or the like means a crystal axis, a crystal plane, a crystal orientation, or the like, respectively, of a GaN substrate or a GaN layer unless otherwise specified.

In the present specification, each concentration, such as Ni concentration, C concentration, O concentration, and Si concentration at a specific position, is a value determined by the corresponding detection amount using secondary ion mass spectrometry (SIMS).

In the present specification, a numerical range expressed using "to" means that the numerical values or physical property values before and after "to" are included in the numerical range. That is, "A to B" means A or more and B or less.

In the present specification, mass ppm and weight ppm are synonymous.

GaN Crystal

The GaN crystal according to the present embodiment includes a Ni-doped GaN layer. The Ni-doped GaN layer has a Ni concentration of $1.0 \times 10^{16}$ atoms/cm$^3$ or more and $1.0 \times 10^{20}$ atoms/cm$^3$ or less. In addition, the Ni-doped GaN layer preferably satisfies at least one of requirements (1) and (2) below and more preferably satisfies both requirements (1) and (2):

(1) the Ni-doped GaN layer has a total donor impurity concentration of less than $2.0 \times 10^{17}$ atoms/cm$^3$; and

(2) the full width at half maximum of a rocking curve of the Ni-doped GaN layer by (004) X-ray diffraction is 50 arcsec or less.

The Ni-doped GaN layer is composed of a crystal layer of GaN doped with Ni; the GaN layer is made highly resistive by containing Ni at a specific concentration, and the resistivity can be maintained high even in high-temperature environments. This is more evident when the Ni-doped GaN layer satisfies at least one of requirements (1) and (2). The "high temperature" in the present specification means, for example, a temperature of 500 K or higher.

In one aspect of the GaN crystal according to the present embodiment, the Ni concentration in the entire crystal is $1.0 \times 10^{16}$ atoms/cm$^3$ or more and $1.0 \times 10^{20}$ atoms/cm$^3$ or less. That is, the GaN crystal is composed only of the Ni-doped GaN layer.

In addition, in another aspect of the GaN crystal according to the present embodiment, the GaN crystal has a Ni-doped GaN layer with a Ni concentration of $1.0 \times 10^{16}$ atoms/cm$^3$ or more and $1.0 \times 10^{20}$ atoms/cm$^3$ or less. In this case, the thickness of the Ni-doped GaN layer in the c-axis direction does not need to be equal to the thickness of the entire GaN crystal in the c-axis direction.

For example, while the thickness of the entire GaN crystal is 400 $\mu$m, it is sufficient for the Ni-doped GaN layer to have a thickness of 50 $\mu$m in the surface of the GaN crystal. Of course, the thickness of the entire GaN crystal and the thickness of the Ni-doped GaN layer are not limited to the above; larger or smaller thicknesses than the above are in no way excluded.

In addition, the GaN crystal may be a GaN crystal in which the entire thickness direction of the GaN crystal is composed of the Ni-doped GaN layer, and in this case, the Ni concentration in the entire GaN crystal is $1.0 \times 10^{16}$ atoms/cm$^3$ or more and $1.0 \times 10^{20}$ atoms/cm$^3$ or less.

The Ni-doped GaN layer with a Ni concentration of $1.0 \times 10^{16}$ atoms/cm$^3$ or more and $1.0 \times 10^{20}$ atoms/cm$^3$ or less may have various thicknesses and can take various forms, such as a self-supporting substrate, an epitaxial layer grown on another GaN crystal, or a GaN layer laminated on a support substrate by a bonding technique.

For example, from the viewpoint of handling properties, such as the processability for producing a self-supporting GaN substrate, the thickness of the Ni-doped GaN layer is preferably 50 $\mu$m or more, more preferably 80 $\mu$m or more, and even more preferably 100 $\mu$m or more. The upper limit of the thickness is not particularly limited, but is, for example, preferably 200 $\mu$m or less.

The Ni concentration of the Ni-doped GaN layer is $1.0 \times 10^{16}$ atoms/cm$^3$ or more and $1.0 \times 10^{20}$ atoms/cm$^3$ or less. Ni, a compensating impurity, contributes to increasing the resistance and can achieve high resistivity of the Ni-doped GaN layer even in high-temperature environments with the Ni concentration of $1.0 \times 10^{16}$ atoms/cm$^3$ or more.

Although the reason for this is not clear yet, the GaN layer containing Ni has a large activation energy Ea of resistivity as described later, and this is presumed to contribute to the above. In addition, the Ni-doped GaN layer with a Ni concentration of $1.0 \times 10^{20}$ atoms/cm$^3$ or less can maintain good crystal quality.

The Ni concentration of the Ni-doped GaN layer is $1.0 \times 10^{20}$ atoms/cm$^3$ or less but is preferably, in a stepwise manner, $6.0 \times 10^{19}$ atoms/cm$^3$ or less, $5.0 \times 10^{19}$ atoms/cm$^3$ or less, $3.0 \times 10^{19}$ atoms/cm$^3$ or less, $1.0 \times 10^{19}$ atoms/cm$^3$ or less, and $5.0 \times 10^{18}$ atoms/cm$^3$ or less.

In addition, the Ni concentration of the Ni-doped GaN layer is $1.0 \times 10^{16}$ atoms/cm$^3$ or more, but is preferably, in a stepwise manner, $3.0 \times 10^{16}$ atoms/cm$^3$ or more, $5.0 \times 10^{16}$ atoms/cm$^3$ or more, $1.0 \times 10^{17}$ atoms/cm$^3$ or more, and $2.0 \times 10^{17}$ atoms/cm$^3$ or more.

The C concentration of the Ni-doped GaN layer is preferably $1.0 \times 10^{18}$ atoms/cm$^3$ or less. While C, a compensating impurity, can contribute to increasing the resistance, if contained in a certain amount or more, C may cause a current collapse phenomenon when the GaN crystal including the Ni-doped GaN layer is used in a device. Thus, from the viewpoint of reducing the risk of causing the current collapse phenomenon, the C concentration of the Ni-doped GaN layer is preferably low.

The C concentration of the Ni-doped GaN layer is preferably $1.0 \times 10^{18}$ atoms/cm$^3$ or less but is preferably, in a stepwise manner, $8.0 \times 10^{17}$ atoms/cm$^3$ or less, $5.0 \times 10^{17}$ atoms/cm$^3$ or less, $3.0 \times 10^{17}$ atoms/cm$^3$ or less, $1.0 \times 10^{17}$ atoms/cm$^3$ or less, $5.0 \times 10^{16}$ atoms/cm$^3$ or less, and $2.0 \times 10^{16}$ atoms/cm$^3$ or less. The lower limit of the C concentration of the GaN crystal is not particularly limited and is usually equal to the detection limit.

As impurities that act as donors for GaN, oxygen (O), silicon (Si), sulfur (S), germanium (Ge), tin (Sn), and the like are known and are referred to as donor impurities.

The donor impurity inhibits the effect of the compensating impurity in increasing the resistance. Thus, the sum of the concentrations of the donor impurities in the Ni-doped GaN layer, that is, the total donor impurity concentration, is preferably less than $2.0 \times 10^{17}$ atoms/cm$^3$ from the viewpoints that the resistivity of the Ni-doped GaN layer is less likely to be affected by the variation in the donor impurity concentration and that high resistivity can be achieved even with a relatively low Ni concentration (requirement 1). The donor impurity concentration is more preferably $1.0 \times 10^{17}$ atoms/cm$^3$ or less, even more preferably less than $5.0 \times 10^{16}$ atoms/cm$^3$, still more preferably less than $4.0 \times 10^{16}$ atoms/cm$^3$, and particularly preferably less than $3.0 \times 10^{16}$ atoms/cm$^3$. The donor impurity amount is preferably as small as possible, and thus the lower limit of the total donor impurity concentration is not particularly limited.

As described later, the Ni-doped GaN layer in the present embodiment can be grown, for example, preferably by a vapor phase epitaxy method and more preferably by a hydride vapor phase epitaxy (HVPE) method.

The Ni-doped GaN layer produced by the above method can contain donor impurities, such as oxygen (O) and silicon (Si), each at a concentration on the order of $10^{15}$ atoms/cm$^3$ or more, although they are not intentionally added. That is, both an oxygen (O) concentration and a silicon (Si) concentration in the Ni-doped GaN layer in the present embodiment can be $1.0 \times 10^{15}$ atoms/cm$^3$ or more.

The oxygen (O) concentration of the Ni-doped GaN layer in the present embodiment can be $2.0 \times 10^{15}$ atoms/cm$^3$ or more, $5.0 \times 10^{15}$ atoms/cm$^3$ or more, $8.0 \times 10^{15}$ atoms/cm$^3$ or more, or $1.0 \times 10^{16}$ atoms/cm$^3$ or more.

In addition, the upper limit of the oxygen (O) concentration can be $5.0 \times 10^{16}$ atoms/cm$^3$ or less, or $4.0 \times 10^{16}$ atoms/cm$^3$ or less.

On the other hand, the Ni-doped GaN layer contains a non-negligible concentration of a donor impurity other than O and Si only when intentionally doped with such a donor impurity. "Intentionally doped" means a case where the Ni-doped GaN layer is doped with a target element by, for example, adding, as a raw material, a simple substance or compound of the target element.

Thus, unless the Ni-doped GaN layer is intentionally doped with a donor impurity other than O and Si, the total donor impurity concentration in the Ni-doped GaN layer may be regarded as being equal to the sum of the O and Si concentrations. Whether the Ni-doped GaN layer is doped with a donor impurity other than O and Si can be confirmed by elemental analysis or the like.

The Ni-doped GaN layer may contain a compensating impurity other than Ni, such as iron (Fe), cobalt (Co), or manganese (Mn), as long as it does not cause any practical problem. Alternatively, the Ni-doped GaN layer may be one containing substantially no compensating impurity other than Ni.

The sum of the concentrations of compensating impurities other than Ni in the Ni-doped GaN layer is, for example, $5 \times 10^{16}$ atoms/cm$^3$ or less. In one example of a preferred aspect, the sum of the concentrations of compensating impurities other than Ni and carbon (C) in the Ni-doped GaN layer is $5 \times 10^{16}$ atoms/cm$^3$ or less.

The Ni-doped GaN layer may contain hydrogen (H) in addition to the donor impurity and compensating impurity mentioned above. The concentration may be, for example, on the order of $10^{16}$ to $10^{17}$ atoms/cm$^3$. However, in the case of the Ni-doped GaN layer produced by the HVPE method described above, the upper limit of the hydrogen (H) concentration can be $3.0 \times 10^{17}$ atoms/cm$^3$ or less, $2.0 \times 10^{17}$ atoms/cm$^3$ or less, or $1.0 \times 10^{17}$ atoms/cm$^3$ or less.

The Ni-doped GaN layer may also contain, as an additional impurity, an alkali metal element, such as lithium (Li), sodium (Na), or potassium (K); or a halogen element, such as fluorine (F), chlorine (Cl), bromine (Br), and iodine (I). However, in the case of the Ni-doped GaN layer produced by the HVPE method described above, the content of these impurities can be kept low.

In this case, the total content of halogen elements in the Ni-doped GaN layer can be $1 \times 10^{16}$ atoms/cm$^3$ or less.

In the Ni-doped GaN layer in the present embodiment, the alkali metal concentration on the crystal surface is preferably 10 mass ppm or less. Satisfaction of the above requirement by the Ni-doped GaN layer means that no region with a locally high alkali metal concentration is present in the Ni-doped GaN layer. The absence of a region with a locally high alkali metal concentration can prevent or reduce the effect on the lattice length of the GaN crystal and can prevent or reduce cracking or the like when the GaN crystal including the Ni-doped GaN layer is used as a substrate.

The alkali metal concentration on the crystal surface is more preferably 8 mass ppm or less and even more preferably 5 mass ppm or less. The concentration is preferably as low as possible, but is usually 0.1 mass ppm or more. The alkali metal concentration in the present specification means the alkali metal concentration in any 100 $\mu$m $\times$ 100 $\mu$m square grid on the crystal surface and can be measured, for example, by scanning electron microscopy-energy dispersive X-ray spectroscopy (SEM-EDX).

In the Ni-doped GaN layer in the present embodiment, the Ni concentration is $1.0 \times 10^{16}$ atoms/cm$^3$ or more and $1.0 \times 10^{20}$ atoms/cm$^3$ or less. In addition to this, the Ni-doped GaN layer preferably further satisfies one or more of the following: the C concentration is $1.0 \times 10^{18}$ atoms/cm$^3$ or less; the donor impurity concentration is less than $2.0 \times 10^{17}$ atoms/cm$^3$ (requirement 1); the sum of the concentrations of compensating impurities other than Ni is $5 \times 10^{16}$ atoms/cm$^3$ or less; the H concentration is $3.0 \times 10^{17}$ atoms/cm$^3$ or less; the total content of halogen elements is $1 \times 10^{16}$ atoms/cm$^3$ or less; and the alkali metal concentration on the crystal surface is 10 mass ppm or less. The Ni-doped GaN layer more preferably further satisfies two or more, still more preferably three or more, yet more preferably four or more, still even more preferably five or more, and particularly preferably all six of these.

The Ni-doped GaN layer in the present embodiment preferably does not contain an alkali metal inclusion. The alkali metal inclusion means a space containing an alkali metal. When present inside the crystal, it refers to a closed space formed in the Ni-doped GaN layer. When present on the crystal surface, it refers to a recess formed by exposure of the closed space at the crystal surface.

Using a GaN crystal including a Ni-doped GaN layer containing an alkali metal inclusion inside the crystal or on the crystal surface as a substrate may cause the substrate to crack, for example, due to volume expansion resulting from volatilization of the alkali metal, such as Na, contained in the closed space during epitaxial growth of the GaN crystal layer on the substrate, or may degrade the crystal quality of the epitaxially grown GaN crystal layer. It is known that such a closed space can generally occur in a crystal when a GaN crystal is produced by a flux method. The presence or absence of an alkali metal inclusion can be determined with an optical microscope or SEM.

A peak of light emitted when the Ni-doped GaN layer in the present embodiment is irradiated with light having energy greater than the band gap energy of GaN is preferably not present in the region of 2.64 to 2.82 eV. It is known that when a GaN crystal produced, for example, by a Na flux method among flux methods is irradiated with the above light, the GaN crystal has broad emission having a peak generally at 2.64 to 2.82 eV. A GaN crystal having the peak can be presumed to be the GaN crystal produced by the Na flux method.

As described above, in a GaN crystal produced by a flux method, a region with a high alkali metal concentration may be present on the crystal surface, or an alkali metal inclusion may be present. Such a GaN crystal may be undesirable as a semi-insulating GaN crystal for a device requiring high reliability.

The full width at half maximum of a rocking curve of the Ni-doped GaN layer by (004) X-ray diffraction is preferably 50 arcsec or less (requirement 2). The rocking curve is a diffraction intensity distribution in X-ray diffraction measurement where the direction of an incident X-ray and the position of a detector are fixed and only the crystal used as a sample is rotated, and is one of the indices indicating crystal quality.

A smaller value of the full width at half maximum of the rocking curve means fewer crystal defects and better crystal quality.

The full width at half maximum of the rocking curve by (004) X-ray diffraction is more preferably 40 arcsec or less, even more preferably 30 arcsec or less, and still more preferably 20 arcsec or less. The lower limit of the full width at half maximum is not particularly limited but is usually 5 arcsec or more.

The full width at half maximum in the present specification is synonymous with what is generally called a half width. That is, the full width at half maximum means the distance between the positions showing an intensity of $1/2f_{max}$, half the maximum intensity $f_{max}$ of the peak.

The full width at half maximum can be adjusted by the growth method of the GaN crystal layer in the Ni-doped GaN layer (such as a gas-phase method or a liquid-phase method), the crystal properties of a seed substrate used for growing the GaN crystal layer, the crystal growth conditions, the selection of the surface for growing the GaN crystal layer, the impurity content, and the like.

The rocking curve measurement by (004) X-ray diffraction uses CuK$\alpha$1 radiation. In the measurement, the X-ray tube is operated, for example, at a voltage of 45 kV and a current of 40 mA. When X-rays are incident on the (0001) surface, the plane of incidence of the X-rays can be perpendicular to the a-axis or the m-axis.

The X-ray beam size can be set so that, when the incident angle (the angle formed by the reflecting surface and the X-rays) is 90°, that is, when the X-rays are incident perpendicular to the (004) plane, a reflecting surface, the size of the irradiation area on the (0001) surface is 5 mm in the direction parallel to the $\omega$-axis and 1 mm in the direction perpendicular to the $\omega$-axis. The $\omega$-axis is the rotation axis of the sample in the rocking curve measurement, and the angle between the incident X-rays and the crystal surface is represented by $\omega$.

When the X-ray beam size is thus set, $\omega$ is about 36.5° in the rocking curve measurement by (004) X-ray diffraction, and thus the size of the irradiation area is about $1.7 \times 5$ mm$^2$.

In addition, in the same manner as the measurement of the (004) plane, rocking curves of other crystal planes can also be measured. For example, the (201) plane is often measured.

The full width at half maximum in the rocking curve of (004) is an index for observing the uniformity of a plane parallel to the c-axis, that is, the c-plane. On the other hand, the full width at half maximum in the rocking curve of the (201) plane is an index for observing the rotational uniformity of a plane not parallel to the c-axis, that is, a plane around the c-axis of the c-plane.

The rocking curve measurement of a plane parallel to the c-axis is referred to as an on-axis measurement, and the rocking curve measurement of a plane not parallel to the c-axis is referred to as an off-axis measurement. The former correlates with the dislocation density having a screw dislocation component, and the latter correlates with the dislocation density having an edge displacement component. To evaluate the crystal quality, both the on-axis measurement and the off-axis measurement are preferably performed.

The threading dislocation density of the Ni-doped GaN layer (which may hereinafter be referred to as "dislocation density") is preferably less than $1 \times 10^7$ cm$^{-2}$, and from the viewpoint of crystallinity, more preferably $5 \times 10^6$ cm$^{-2}$ or less and even more preferably $1 \times 10^6$ cm$^{-2}$ or less. The lower limit of the threading dislocation density is not particularly limited, but is usually $1 \times 10^2$ cm$^{-2}$ or more.

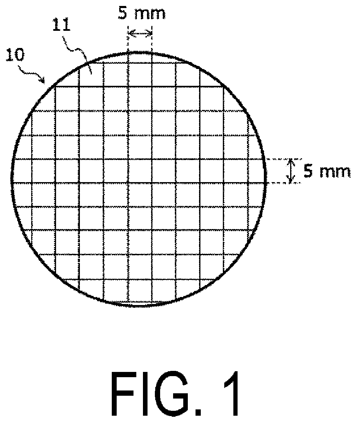

In addition, when the (0001) plane 11 of the GaN crystal 10 according to the present embodiment is divided into 5 mm $\times$ 5 mm cells by a square grid as illustrated in FIG. 1, at least one 100 $\mu$m $\times$ 100 $\mu$m square region without a threading dislocation is preferably present in each 5 mm $\times$ 5 mm cell in the Ni-doped GaN layer.

The dislocation density can be adjusted by the growth method of the GaN crystal layer, such as a gas-phase method or a liquid-phase method, the crystal properties of a seed substrate used for growing the GaN crystal layer, the crystal growth conditions, the selection of the surface for growing the GaN crystal layer, the impurity content, and the like.

The dislocation density is synonymous with the dark spot density by the cathode luminescence (CL) method.

In addition, there are three types of threading dislocations: edge, screw, and mixed. However, in the present specification, these are not distinguished and are collectively referred to as threading dislocations.

The presence or absence and the density of threading dislocations in the Ni-doped GaN layer can be examined with a multiphoton excitation microscope. Dark spots observed in a multiphoton excitation microscope image are confirmed by examining their correspondence with dark spots appearing in a cathodoluminescence (CL) image.

As described above, the GaN crystal according to the present embodiment may be composed of a Ni-doped GaN crystal in which the Ni concentration in the entire crystal is $1.0 \times 10^{16}$ atoms/cm$^3$ or more and $1.0 \times 10^{20}$ atoms/cm$^3$ or less. That is, the GaN crystal may be composed only of the Ni-doped GaN layer, but can have a configuration in which the Ni-doped GaN layer with the Ni concentration of $1.0 \times 10^{16}$ atoms/cm$^3$ or more and $1.0 \times 10^{20}$ atoms/cm$^3$ or less is laminated on a seed crystal layer composed of GaN.

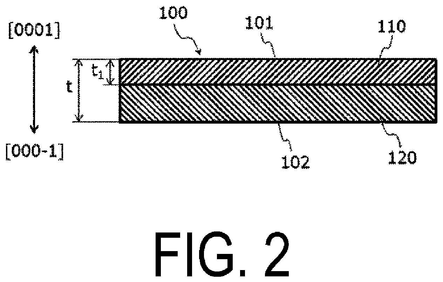

In a GaN crystal including the Ni-doped GaN layer and the seed crystal layer, as illustrated in FIG. 2, the GaN crystal includes a first region 110 and a second region 120.

FIG. 2 illustrates a cut surface when the GaN crystal 100 is cut along a plane perpendicular to the (0001) surface 101.

In the GaN crystal 100, the first region 110 including the (0001) surface 101 is preferably composed of a Ni-doped GaN layer.

The GaN crystal 100 has a second region 120 on the (000-1) surface 102 side, and the second region 120 may be composed of a GaN crystal layer with a room temperature resistivity of less than $1 \times 10^5 \, \Omega$ cm, that is, a non-semi-insulating GaN crystal layer. In the present specification, "room temperature" means 293 K.

The total concentration of compensating impurities in the second region 120 is usually lower than that in the first region 110. The second region 120 may have, in the vicinity of the boundary with the first region 110, a region in which the total concentration of compensating impurities increases stepwise or continuously toward the first region 110.

The GaN crystal 100 having the first region 110 and the second region 120 can be produced by forming the second region 120 on the first region 110 by epitaxial growth, or by forming the first region 110 on the second region 120 by epitaxial growth.

An example of the GaN crystal according to the present embodiment has a (0001) surface 101 with Ga polarity and a (000-1) surface 102 with N polarity.

In the GaN crystal 100 including the seed crystal layer and the Ni-doped GaN layer, as illustrated in FIG. 2, the surface of the first region 110, which is the Ni-doped GaN layer, is the (0001) surface 101, and the surface of the second region 120, which is the seed crystal layer, is the (000-1) surface 102.

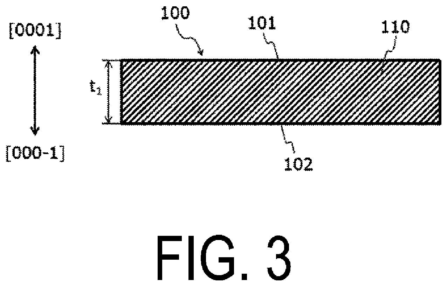

In the GaN crystal 100 entirely composed only of the Ni-doped GaN layer, as illustrated in FIG. 3, one surface of the Ni-doped GaN layer, which is the first region 110, is the (0001) surface 101, and the other surface is the (000-1) surface 102.

The Ni-doped GaN layer in the present embodiment preferably has a surface inclined at 10 degrees or less from the (0001) crystal plane. In the present specification, "surface inclined at 10 degrees or less from the (0001) crystal plane" may be collectively referred to as "(0001) surface". In addition, "inclined at 10 degrees or less" is a concept including 0 degrees.

The GaN crystal according to the present embodiment has any shape and preferably has a shape that provides a GaN substrate described later.

The area of the (0001) surface of the Ni-doped GaN layer may be, for example, 1 cm$^2$ or more, 5 cm$^2$ or more, 10 cm$^2$ or more, 18 cm$^2$ or more, 75 cm$^2$ or more, or 165 cm$^2$ or more. The upper limit is not particularly limited but may be, for example, 350 cm$^2$ or less.

The GaN crystal according to the present embodiment may be grown in any direction, but is preferably grown on a plane inclined at 10 degrees or less (including 0 degrees) from the (0001) crystal plane.

The GaN crystal according to the present embodiment preferably has the (0001) surface as a main surface, that is, a large-area surface. In addition, the proportion of the area of the (0001) surface in the crystal growth surface is preferably 60% or more, more preferably 70% or more, and even more preferably 80% or more, with an upper limit of 100%.

As described later, the large-area (0001) surface allows the GaN crystal to keep the total donor impurity concentration low and to have semi-insulating properties even at a relatively low Ni concentration. The same applies when the proportion of the area of the (0001) surface in the crystal growth surface is within the above range.

In a case where the GaN crystal according to the present embodiment is disc-shaped, its diameter is usually 20 mm or more, and can be, in a stepwise manner, 25 mm or more, 40 mm or more, 50 mm or more, and 90 mm or more. In addition, the diameter can also be any size, such as from 25 to 27 mm (about 1 inch), from 50 to 55 mm (about 2 inches), from 100 to 105 mm (about 4 inches), or from 150 to 155 mm (about 6 inches). For the GaN crystal with a shape other than a disk, the size can be employed so that the diameter of a disk with the same area as that of its main surface is the above size.

In the case of using the GaN crystal according to the present embodiment as a GaN substrate, its thickness is set to a value according to the diameter so that the GaN substrate can be handled without difficulty. For example, when the diameter of the GaN crystal is about 2 inches, the thickness t of the GaN crystal is preferably from 250 to 500 $\mu$m and more preferably from 300 to 450 $\mu$m. Here, the thickness t is preferably 250 $\mu$m or more and more preferably 300 $\mu$m or more, and is preferably 500 $\mu$m or less and more preferably 450 $\mu$m or less.

For the GaN crystal according to the present embodiment with a configuration in which the second region 120 composed of the seed crystal layer and the first region 110 composed of the Ni-doped GaN layer are laminated as illustrated in FIG. 2, the thickness $t_1$ of the first region 110, which is the Ni-doped GaN layer, is preferably from 50 to 200 $\mu$m, more preferably from 80 to 200 $\mu$m, and even more preferably from 100 to 150 $\mu$m. Here, the thickness $t_1$ is preferably 50 $\mu$m or more, more preferably 80 $\mu$m or more, and even more preferably 100 $\mu$m or more, and is preferably 200 $\mu$m or less and more preferably 150 $\mu$m or less.

In the case of using the GaN crystal according to the present embodiment as a GaN substrate, of the two large-area surfaces of the GaN crystal, the (0001) surface 101 is used as the front surface for epitaxial growth of a nitride semiconductor layer. The (0001) surface 101 is mirror-finished, and its root-mean-square (RMS) roughness measured with an atomic force microscope (AFM) in a measurement range of 2 $\mu$m $\times$ 2 $\mu$m is usually less than 2 nm, preferably less than 1 nm, and more preferably less than 0.5 nm.

The (000-1) surface 102 is a back surface and thus may be mirror-finished or matte-finished (rough surface).

The edge of the GaN substrate composed of the GaN crystal according to the present embodiment may be chamfered.

The GaN substrate may be provided with any of various markings as necessary, such as an orientation flat or notch indicating the orientation of the crystal, or an index flat for facilitating the identification of the front and back surfaces.

The shape of the GaN substrate is not particularly limited, and the shape of the (0001) surface and the (000-1) surface may be a disk, a square, a rectangle, a hexagon, an octagon, an ellipse, or the like, or may be an irregular shape.

In the GaN crystal of the present embodiment, an activation energy Ea of resistivity of the Ni-doped GaN layer that is obtained by substituting the resistivity into Equation (I) is preferably 0.5 eV or more and more preferably from 0.5 to 1.2 eV:

$$\text{Resistivity } (\Omega \text{ cm}) = A \times \text{EXP}(-Ea/kT) \text{ (I)}$$

where

A is a proportionality constant,
EXP is an exponential function,
Ea is the activation energy (eV) of resistivity,
k is the Boltzmann constant ($8.617 \times 10^{-5}$ eV/K), and
T is temperature (K) in Kelvin.

The activation energy Ea of resistivity is 0.5 eV or more, and this tends to prevent or reduce a decrease in the resistivity at high temperatures and to allow a GaN substrate maintaining high resistance in high-temperature environments to be produced. From the same viewpoint, the activation energy Ea of resistivity is preferably 0.7 eV or more, more preferably 0.8 eV or more, and even more preferably 0.9 eV or more, and is preferably 1.2 eV or less and more preferably 1.1 eV or less.

The activation energy Ea of resistivity is preferably determined by the least squares method from a scatter plot of resistivity and 1/T using two or more temperatures T.

The temperature range for determining the activation energy Ea of resistivity is not particularly limited, but from the viewpoint of data reliability, the Ea of resistivity is preferably determined using resistivity values measured at temperatures of 450 K or higher. This is because the Ni-doped GaN layer has a very high resistivity, thus making accurate measurement difficult at ordinary temperature, that is, at or near 293 K. In contrast, measurement at temperatures of 450 K or higher reduces the resistivity to a measurable range, making it possible to obtain a more accurate Ea of resistivity.

In the case of determining the activation energy Ea of resistivity by the least squares method, the coefficient of determination $R^2$ of the approximation curve in the exponential approximation of the least squares method is preferably 0.85 or more and more preferably closer to 1, from the viewpoint of higher reliability of the value of the activation energy Ea of resistivity.

Specifically, the activation energy Ea of resistivity can be a value obtained by the least squares method by substituting resistivity measured at 20 K intervals in a temperature range of 700 K to 800 K into Equation (I) above.

The resistivity and the carrier type described later can be determined using the Hall effect measurement.

In the GaN crystal of the present embodiment, the resistivity at 700 K of the Ni-doped GaN layer is preferably $5 \times 10^5 \, \Omega$ cm or more because the resistivity does not decrease even when the GaN substrate is used in high-temperature environments, enabling operation in a wide range of application environments.

The resistivity at 700 K is more preferably $8 \times 10^5 \, \Omega$ cm or more, even more preferably $1 \times 10^6 \, \Omega$ cm or more, and particularly preferably $1.5 \times 10^6 \, \Omega$ cm or more. In addition, a higher resistivity is preferred, and thus the upper limit is not particularly limited.

In the GaN crystal of the present embodiment, the resistivity at 800 K of the Ni-doped GaN layer is preferably $5 \times 10^4 \, \Omega$ cm or more because the resistivity does not decrease even when the GaN substrate is used in high-temperature environments, enabling operation in a wide range of application environments.

The resistivity at 800 K is more preferably $1 \times 10^5 \, \Omega$ cm or more, even more preferably $2 \times 10^5 \, \Omega$ cm or more, and particularly preferably $3 \times 10^5 \, \Omega$ cm or more. In addition, a higher resistivity is preferred, and thus the upper limit is not particularly limited.

In the Ni-doped GaN layer in the present embodiment, the type of carrier is preferably p-type. In a GaN single crystal layer with poor crystal quality, even if the GaN layer is doped with Ni to form a Ni-doped GaN layer, electrons cannot be sufficiently compensated due to unintended impurities, such as Si and O, and the GaN layer tends to become n-type. Thus, the type of carrier of the Ni-doped GaN layer being p-type means that the GaN single crystal layer constituting the GaN crystal has good crystallinity.

Method for Producing GaN Crystal

The present invention relates to a method for producing the GaN crystal described in the above "GaN Crystal". That is, one aspect of the production method according to the present embodiment relates to a method for producing a GaN crystal including a Ni-doped GaN layer with a Ni concentration of $1.0 \times 10^{16}$ atoms/cm$^3$ or more and $1.0 \times 10^{20}$ atoms/cm$^3$ or less. In addition, one aspect of the production method according to the present embodiment relates to a method for producing a GaN crystal including a Ni-doped GaN layer having a Ni concentration of $1.0 \times 10^{16}$ atoms/cm$^3$ or more and $1.0 \times 10^{20}$ atoms/cm$^3$ or less and satisfying at least one of requirement (1) a total donor impurity concentration is less than $2.0 \times 10^{17}$ atoms/cm$^3$; and requirement (2) the full width at half maximum of a rocking curve by (004) X-ray diffraction is 50 arcsec or less.

The Ni-doped GaN layer can be produced, for example, by a vapor phase epitaxy method or a liquid phase epitaxy method.

Examples of the vapor phase epitaxy method include an HVPE method, and examples of the liquid phase epitaxy method include an acidic ammonothermal method and a basic ammonothermal method. Among these, the method is preferably an HVPE method from the viewpoint of ease of production.

The method for producing a GaN crystal according to the present embodiment is a method for producing the Ni-doped GaN layer described above by a vapor phase epitaxy method, in which nickel dichloride is preferably used as a doping precursor, and the GaN crystal is more preferably produced by an HVPE method.

Hereinafter, the method for producing a GaN crystal according to the present embodiment will be described using an HVPE method as an example.

The method for producing a GaN crystal according to the present embodiment by an HVPE method preferably includes a first step (i) below. This method is applied to the production of a GaN crystal having a region on the N polarity side and a region on the Ga polarity side with a regrowth interface between these regions, and more preferably, the resistivity is increased in at least a part of the Ga polarity side.

(i) A first step of growing a (0001)-oriented Ni-doped GaN layer on a c-plane GaN seed by an HVPE method to form a Ni-doped GaN layer.

In the present specification, "on a substrate" is synonymous with "on a surface of a substrate".

The first step will be described in more detail below.

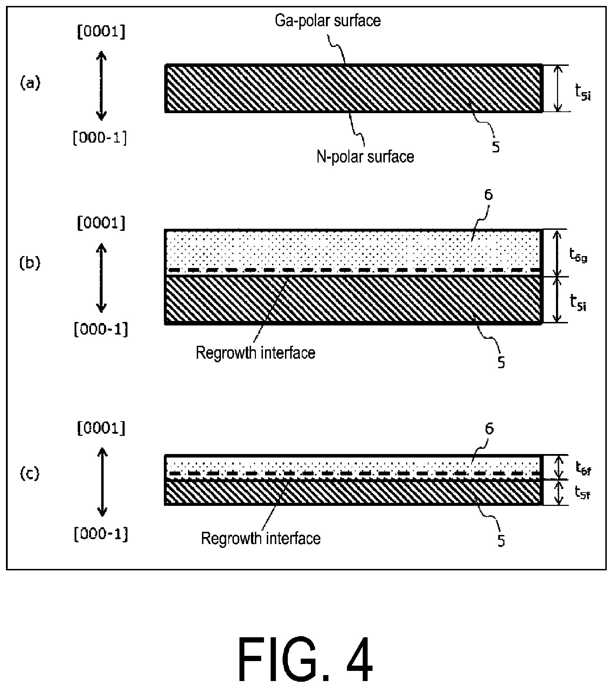

In the first step, as illustrated in FIGS. 4(a) and 4(b), a (0001)-oriented GaN layer 6 is grown on a Ga-polar surface of a c-plane GaN seed 5 by an HVPE method to produce a GaN layer having a laminated structure. A growth thickness $t_{6g}$ of the GaN layer 6 is preferably more than 50 $\mu$m. At this time, a regrowth interface is formed between the c-plane GaN seed 5 and the GaN layer 6.

The method for producing the c-plane GaN seed 5 used in the first step is not particularly limited.

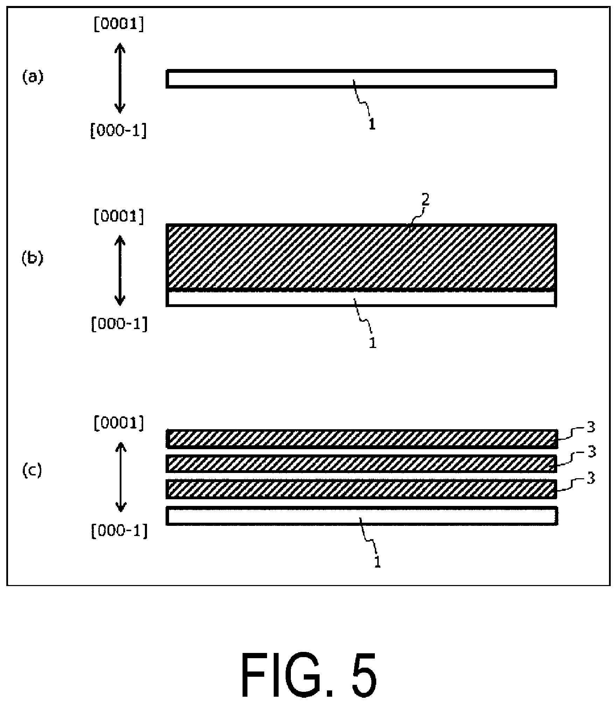

For example, after preparing a seed wafer 1 illustrated in FIG. 5(a), a (0001)-oriented GaN thick film 2 composed of GaN not intentionally doped is grown on the seed wafer 1 by an HVPE method as illustrated in FIG. 5(b). Furthermore, as illustrated in FIG. 5(c), by processing the GaN thick film 2, at least one c-plane GaN seed 3 serving as a substrate can be produced.

An example of the seed wafer 1 is a c-plane sapphire wafer, and preferably, a peeling layer may be provided on its main surface. In addition, a c-plane substrate produced by further growing a GaN thick film by an HVPE method on the c-plane GaN seed 3 thus produced and processing the GaN thick film may be used as the c-plane GaN seed used in the first step.

Usually, the Ga-polar surface of the c-plane GaN seed 5 undergoes a planarization step, that is, a step of planarizing the Ga-polar surface appropriately using a technique, such as grinding, polishing, or a processing technique called chemical mechanical polishing (CMP), which uses a chemical slurry and a polishing pad, before growing the GaN layer 6.

After the planarized Ga-polar surface undergoes a roughening step, that is, a step of processing the Ga-polar surface into a rough surface by etching, the GaN layer 6 may be grown.

In the first step, a Ni-doped GaN layer is formed by doping at least a part of the GaN layer 6 with Ni as a compensating impurity.

This does not exclude doping with Fe as a compensating impurity in addition to Ni.

For doping with Ni, the same method as those used for doping with a compensating impurity in the art can be used; however, for example, an HVPE method is preferred.

Where an HVPE method is used, nickel dichloride is preferably used as the dopant precursor as described above because a GaN crystal with even better crystal quality can be produced.

Where nickel dichloride is used as the raw material gas, the growth rate is preferably 20 $\mu$m/hr or more and 200 $\mu$m/hr or less. Here, from the viewpoint of high productivity, the growth rate is preferably 20 $\mu$m/hr or more and more preferably 40 $\mu$m/hr or more, and from the viewpoint of stable crystal growth, the growth rate is preferably 200 $\mu$m/hr or less, more preferably 150 $\mu$m/hr or less, and even more preferably 100 $\mu$m/hr or less. If the growth rate is too high, the surface morphology of the grown crystal may deteriorate, and this may lead to excessive incorporation of donor impurities into the crystal.

The partial pressure of nickel dichloride is adjusted to control the nickel concentration in the resulting Ni-doped GaN layer within the range described above.

The growth thickness $t_{6g}$ of the GaN layer 6 is set according to the design thickness of the Ga-polarity side region of the GaN crystal to be produced.

In the GaN crystal, even if its diameter is 4 inches or 6 inches, the growth thickness $t_{6g}$ of the GaN layer 6 can be limited to 500 $\mu$m or less.

After the first step, a thinning step is provided as necessary, in which the GaN layer 6 having a laminated structure is thinned as illustrated in FIG. 4(c).

In FIG. 4(c), the thickness of the c-plane GaN seed 5 is reduced from the initial thickness $t_{5i}$ to the final thickness $t_{5f}$, and the thickness of the GaN layer 6 is reduced from the initial thickness $t_{6i}$ to the final thickness $t_{6f}$. However, in the thinning step, only one of the c-plane GaN seed 5 or the GaN layer 6 may be processed.

When the off-cut orientation of the GaN crystal to be produced is the same as that of the c-plane GaN seed 5, the back surface of the c-plane GaN seed 5 (the N-polar surface of the laminated structure) can be used as a reference for plane orientation during the thinning process.

When the off-cut orientation of the GaN crystal to be produced is different from that of the c-plane GaN seed 5, that is, when at least one of the off-cut angle or the off-cut direction is different, the crystal orientation of the GaN layer forming the laminated structure is confirmed by an X-ray diffractometer before the thinning process.

The processing technique used in the thinning step can be appropriately selected from grinding, lapping, CMP, dry etching, wet etching, and the like.

Using the production method described above enables high-yield production of the GaN crystal in the present embodiment.

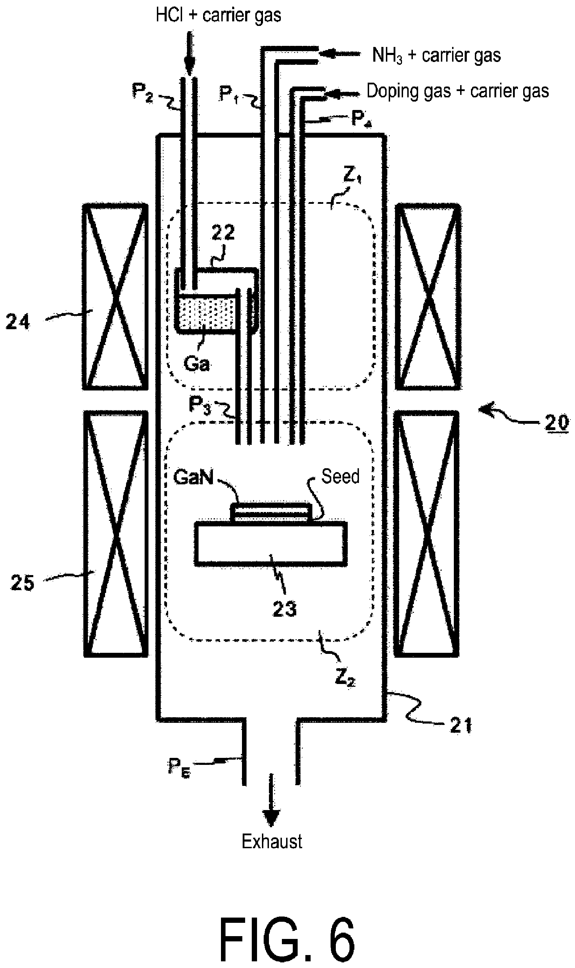

Next, an example of an HVPE apparatus that can be used in the first step included in the above-described production method will be described below with reference to FIG. 6.

An HVPE apparatus 20 illustrated in FIG. 6 includes a hot wall type reactor 21, a gallium reservoir 22 and a susceptor 23 disposed inside the reactor 21, and a first heater 24 and a second heater 25 disposed outside the reactor 21. The first heater 24 and the second heater 25 each annularly surround the reactor 21.

The reactor 21 is a quartz tube chamber. The reactor 21 has, in its inside, a first zone $Z_1$ to be heated mainly by the first heater 24 and a second zone Z2 to be heated mainly by the second heater 25. An exhaust pipe $P_E$ is connected to a reactor end on the second zone $Z_2$ side.

The gallium reservoir 22 disposed in the first zone $Z_1$ is a quartz vessel having a gas inlet and a gas outlet.

The susceptor 23 disposed in the second zone $Z_2$ is formed, for example, of graphite. A mechanism for rotating the susceptor 23 can be optionally provided.

To grow GaN in the HVPE apparatus 20, after a seed is placed on the susceptor 23, the inside of the reactor 21 is heated by the first heater 24 and the second heater 25, and ammonia ($NH_3$) diluted with a carrier gas is supplied through an ammonia inlet pipe $P_1$ to the second zone $Z_2$, and hydrogen chloride (HCl) diluted with a carrier gas is supplied through a hydrogen chloride inlet pipe $P_2$ to the gallium reservoir 22. This HCl reacts with metallic gallium in the gallium reservoir 22, and the resulting gallium chloride (GaCl) is carried through a gallium chloride inlet pipe $P_3$ to the second zone $Z_2$.

In the second zone $Z_2$, $NH_3$ reacts with GaCl, and the resulting GaN crystallizes on the seed placed on the susceptor 23.

When the growing GaN is intentionally doped, a doping gas diluted with a carrier gas is introduced through a dopant inlet pipe $P_4$ into the second zone $Z_2$ inside the reactor 21.

For each of the ammonia inlet pipe $P_1$, the hydrogen chloride inlet pipe $P_2$, the gallium chloride inlet pipe $P_3$, and the dopant inlet pipe $P_4$, a portion disposed inside the reactor 21 is formed of quartz.

The carrier gas used for diluting each of $NH_3$, HCl, and the doping gas is hydrogen gas ($H_2$), nitrogen gas ($N_2$), or a mixed gas of $H_2$ and $N_2$. In particular, it is more preferred to use only $N_2$ gas as the carrier gas for diluting each of $NH_3$, HCl, and the doping gas from the viewpoints of efficiency of Ni doping and producing a crystal with good quality. This is probably because a decomposition reaction of nickel dichloride gas may occur when $H_2$ gas is present.

The preferred conditions for growing GaN using the HVPE apparatus 20 are as follows.

The temperature of the gallium reservoir is, for example, from 500 to 1000°C. Here, the temperature of the gallium reservoir is preferably 500°C or higher and more preferably 700°C or higher, and is preferably 1000°C or lower and more preferably 900°C or lower.

The susceptor temperature is, for example, from 900 to 1100°C. Here, the susceptor temperature is preferably 900°C or higher, more preferably 930°C or higher, and even more preferably 950°C or higher, and is preferably 1100°C or lower, more preferably 1050°C or lower, even more preferably 1030°C or lower, and still more preferably 1020°C or lower.

A V/III ratio, which is a ratio of the $NH_3$ partial pressure to the GaCl partial pressure inside the reactor, is, for example, from 1 to 20. Here, the V/III ratio is preferably 1 or more, more preferably 2 or more, and even more preferably 3 or more, and is preferably 20 or less and more preferably 10 or less.

Too high or too low a V/III ratio would cause deterioration of the morphology of the growth surface of GaN. The deterioration of the morphology of the growth surface can cause a decrease in crystal quality.

For certain impurities, the incorporation efficiency into the GaN crystal strongly depends on the crystal orientation of the growth surface. Inside a GaN crystal grown under conditions where the growth surface has poor morphology, the uniformity of the concentration of such an impurity decreases. This is due to the presence of facets of various orientations on the growth surface with poor morphology.

A typical example of the impurity whose incorporation efficiency into the GaN crystal clearly varies depending on the crystal orientation of the growth surface is oxygen (O). O is a donor impurity, and thus a decrease in the uniformity of its concentration leads to a decrease in the uniformity of the resistivity.

In addition, the use of too low a V/III ratio would increase the nitrogen vacancy concentration of the growing GaN crystal. The effect of the nitrogen vacancy on the GaN crystal, on a GaN substrate formed using the GaN crystal, or on a nitride semiconductor device formed on the GaN substrate is not yet clear. However, the nitrogen vacancy is a point defect, and thus it is considered that the nitrogen vacancy concentration should be reduced as much as possible.

The growth rate of GaN is preferably from 40 to 200 $\mu$m/h and can be controlled using the product of the $NH_3$ partial pressure and the GaCl partial pressure inside the reactor as a parameter. Too high a growth rate would deteriorate the growth surface morphology of the growing GaN.

When the GaN layer 6 is doped in the first step described above, the supply rate of a doping gas is preferably gradually increased to a predetermined value over several minutes to several tens of minutes from the start of the supply to prevent deterioration of the morphology of the growth surface.

For the same reason, the supply of a doping gas is preferably started at the time when the GaN layer 6 is grown to at least several $\mu$m. Specifically, when the GaN layer is formed in the first step, the GaN layer is preferably grown as an undoped layer without supplying a doping gas for at least 5 $\mu$m or more and preferably at least 10 $\mu$m or more of the initial growth of the GaN layer. This prevents new dislocations from occurring at the interface between the undoped layer and the doped layer and makes it possible to more suitably maintain the quality of the seed crystal.

The method of incorporating Ni and optionally an additional compensating impurity into the GaN layer 6 is not limited, but a method of introducing a doping gas into an HVPE apparatus is usually employed.

The doping gas for Ni doping is as described above, but when nickel dichloride is used as the raw material gas, nickel dichloride gas can be prepared and used on the spot by placing metallic Ni inside the introduction tube, heating the metallic Ni, and flowing hydrogen chloride gas.

The shape of the metallic Ni is not particularly limited, but is preferably a wire shape.

In addition, when the nickel dichloride gas is prepared on the spot, it is also preferred to increase the contact area between the metallic Ni and the hydrogen chloride gas so as to make the concentration of the nickel dichloride gas uniform.

For example, the contact area between gas and solid can be increased by finely crushing metallic Ni to a diameter of several millimeters and packing the finely crushed metallic Ni in a quartz pipe, and passing diluted hydrogen chloride gas through the pipe. This can further improve the uniformity of the crystal quality of the Ni-doped GaN layer and thus is preferred.

The GaN crystal grown using the HVPE apparatus 20 can contain O and Si at concentrations detectable by secondary ion mass spectrometry (SIMS) even when the GaN crystal is not intentionally doped.

The Si source is quartz ($SiO_2$) used for the reactor and the piping inside the reactor. The O source is either or both of such quartz or moisture remaining inside or entering the reactor.

For a component disposed inside the reactor 21, including those omitted in FIG. 6, a component formed of silicon carbide (SiC), silicon nitride (SiNx), boron nitride (BN), alumina, tungsten (W), molybdenum (Mo), and/or the like in addition to quartz and carbon can be used. By doing so, the concentration of each of impurity elements excluding Si, O, and H in the GaN crystal grown using the HVPE apparatus 20 can be independently $5 \times 10^{16}$ atoms/cm$^3$ or less unless the crystal is intentionally doped. In addition, the total donor impurity concentration can also be less than $2.0 \times 10^{17}$ atoms/cm$^3$.

Although an example of the method for producing the GaN crystal having a laminated structure has been described above as the method for producing a GaN crystal according to the present embodiment, the GaN crystal is not limited to a GaN crystal having a laminated structure.

For example, such a GaN crystal can also be produced by growing the GaN layer 6 to a certain thickness or more to form a GaN thick film in the first step described above, and slicing off a GaN crystal, which is a c-plane GaN crystal, from this GaN thick film. At this time, the resulting GaN crystal is composed only of the GaN layer 6.

Selecting the Ni-doped GaN layer with high Ni concentration as a region for slicing off the GaN crystal, which is a c-plane GaN crystal, results in high Ni concentration in the entire region of the resulting GaN crystal. That is, the resulting GaN crystal can be a GaN crystal composed only of the Ni-doped GaN layer in the present embodiment without having the c-plane GaN seed 5.

Applications of GaN Crystal

The GaN crystal according to the present embodiment can preferably be used for manufacturing a nitride semiconductor device, in particular, a nitride semiconductor device with a lateral device structure. Specifically, the nitride semiconductor device can be manufactured, for example, by a method including: preparing the GaN crystal; preparing a substrate from the prepared GaN crystal; and epitaxially growing one or more nitride semiconductor layers on the substrate.

The nitride semiconductor is also referred to as a nitride-based group III-V compound semiconductor, a group III nitride-based compound semiconductor, a GaN-based semiconductor, or the like, and includes GaN and also includes a compound in which gallium of GaN is partially or entirely replaced by another group 13 element (such as B, Al, or In) of the periodic table.

A typical example of the nitride semiconductor device with a lateral device structure is a GaN-HEMT. However, the lateral device structure can also be employed in electronic devices other than HEMTs, such as bipolar transistors, and in light-emitting devices, such as light-emitting diodes (LEDs) and laser diodes (LDs).

Examples

The present invention will be specifically described with reference to Examples below, but the present invention is not limited to these Examples.

Example 1

1. Epitaxial Growth of GaN Crystal

A GaN crystal was epitaxially grown on a self-supporting GaN seed in the form of a square measuring 20 mm on each side and having a thickness of 400 $\mu$m by an HVPE method using a vapor phase epitaxy apparatus equipped with a quartz hot-wall type reactor. The growth surface of the self-supporting GaN seed was inclined at 0.35 degrees from the (0001) plane.

In this step, the following steps were sequentially performed: (1) a temperature increase step, (2) a GaN layer growth step, and (3) a cooling step, which will be described next.

(1) Temperature Increase Step

First, a self-supporting GaN seed was placed inside the reactor.

The reactor temperature was then increased from room temperature to 1030°C while ammonia and a carrier gas were supplied to the self-supporting GaN seed. Nitrogen gas was used as the carrier gas.

(2) Ni-Doped GaN Layer Growth Step

While the reactor temperature was maintained at 1030°C, a mixed gas containing ammonia, gallium chloride, and nickel dichloride and shown in the following growth conditions was supplied as a raw material gas, thereby growing a Ni-doped GaN layer on the self-supporting GaN seed to a thickness of 500 $\mu$m.

The growth rate was 100 $\mu$m/hr, and the growth conditions were as follows: reactor pressure 101 kPa, ammonia partial pressure 15.781 kPa, GaCl partial pressure 1.263 kPa, nitrogen gas partial pressure 83.83 kPa, and nickel dichloride partial pressure $1.14 \times 10^{-3}$ kPa.

Nickel dichloride was produced by passing hydrogen chloride gas through a plurality of metallic Ni wires, each with a length of 10 mm, heated to 840°C. During the initial 20 minutes of growth, an undoped layer was formed without flowing hydrogen chloride gas through the Ni wires.

The partial gas pressure ($P_G$) referred to here is a value obtained by multiplying the reactor pressure ($P_R$) by the ratio (r) of the volume flow rate of the gas to the total volume flow rate of all the gases supplied into the reactor, that is, a value represented by $P_G = r \times P_R$.

(3) Cooling Step

After the completion of the Ni-doped GaN layer growth step (2), the supply of gallium chloride to the self-supporting GaN seed was stopped, and the heating of the reactor was stopped to reduce the reactor temperature to room temperature. Ammonia and nitrogen gas were flowed into the reactor until the temperature dropped to 500°C, and thereafter only nitrogen gas was flowed.

The surface of the as-grown GaN crystal taken out from the reactor was mirror-like and flat over the entire surface.

2. Production of c-Plane GaN Substrate

The as-grown GaN crystal produced in 1 above was subjected to laser coring, and a square epitaxial substrate with a side length of 8 mm was produced. Then, the epitaxial substrate was sequentially subjected to +c-plane and -c-plane lapping and polishing, thereby completing a c-plane GaN substrate composed of a GaN crystal including a Ni-doped GaN layer. In the processing step, the seed portion on the -c-plane side was completely removed by grinding.

The total thickness of the GaN crystal serving as the c-plane GaN substrate was 350 $\mu$m, and the GaN crystal was composed only of the Ni-doped GaN layer. That is, the thickness of the Ni-doped GaN layer was also 350 $\mu$m. In addition, one main surface of the c-plane GaN substrate was inclined at 0.35 degrees from the (0001) crystal plane.

3. Evaluation of c-Plane GaN Substrate

Measurement of Each Element Concentration

The Ni concentration, C concentration, Si concentration, O concentration, and H concentration of the c-plane GaN substrate produced above were measured by SIMS.

As a result, the Ni concentration in the c-plane GaN substrate was $1.5 \times 10^{18}$ atoms/cm$^3$. The C concentration was $2 \times 10^{16}$ atoms/cm$^3$. The Si concentration was $8 \times 10^{16}$ atoms/cm$^3$. The H concentration was $1 \times 10^{17}$ atoms/cm$^3$. The O concentration was $2 \times 10^{16}$ atoms/cm$^3$.

That is, the Ni concentration in the Ni-doped GaN layer was $1.5 \times 10^{18}$ atoms/cm$^3$, the C concentration was $2 \times 10^{16}$ atoms/cm$^3$, the O concentration was $2 \times 10^{16}$ atoms/cm$^3$, the H concentration was $1 \times 10^{17}$ atoms/cm$^3$, the Si concentration was $8 \times 10^{16}$ atoms/cm$^3$, and the total donor impurity concentration was $1.0 \times 10^{17}$ atoms/cm$^3$.

Measurement of Dislocation Density

The dislocation density of the c-plane GaN substrate produced above, that is, the Ni-doped GaN layer, was $1 \times 10^6$ cm$^{-2}$. This indicates that the dislocation density was similar to that of the self-supporting GaN seed used and that the Ni doping did not increase the dislocations.

The dislocation density was measured by the following method.

After the Ni-doped GaN layer was grown for 20 minutes, for the GaN crystal on which the undoped layer was grown for 20 minutes, the dislocation distributions on the crystal surface and the growth interface were observed with a multiphoton excitation microscope. A femtosecond pulsed laser at a wavelength of 1035 nm was used as the exciting light, and emissions from 350 nm to 370 nm from the crystal were imaged with a 50 $\times$ objective lens. The reason for growing the undoped layer is that the Ni-doped GaN layer does not emit light in the range of 350 to 370 nm when excited by the excitation light.

The dislocation density was measured at two points in an observation field of view angle of 115 $\mu$m square, and the average was taken. The dislocation distribution on the crystal surface and the dislocation distribution on the growth interface were found to be almost the same, indicating that the Ni doping did not increase the dislocations.

Measurement of Resistivity and Carrier Type

For Hall measurements, 30-nm Ti and 100-nm Au were successively vacuum-deposited on the surface of the c-plane GaN substrate produced above, that is, the Ni-doped GaN layer.

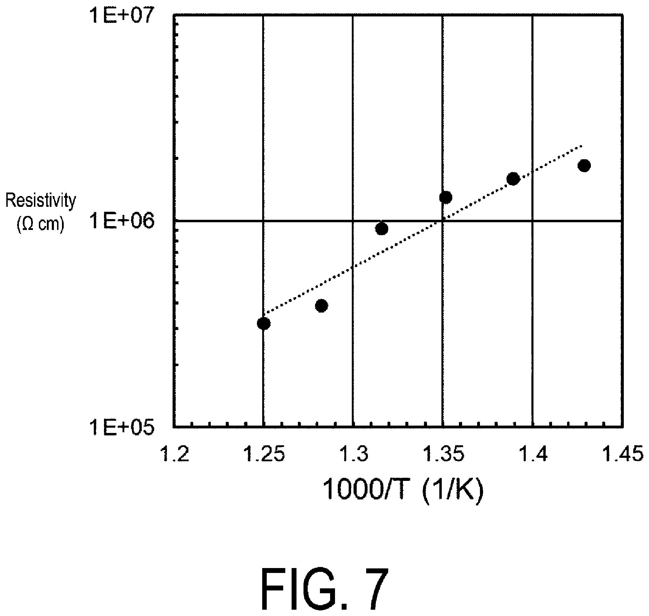

For the Hall measurements, the four-terminal Van der Pauw method was used. In the Hall measurements, the resistivity was measured at six points at 20-K intervals as the measurement temperature was varied from 700 K to 800 K. The results are shown in FIG. 7.

In the graph of FIG. 7, 1000/T (1/K) was plotted on the x-axis, and the resistivity ($\Omega$ cm) was plotted on the y-axis. The resistivity was $1.87 \times 10^6$ $\Omega$ cm at 700 K and $3.20 \times 10^5$ $\Omega$ cm at 800 K; it decreased as the temperature was increased.

The resistivities at the six points were each substituted into Equation (I) [resistivity ($\Omega$ cm) = A $\times$ EXP(-Ea/kT)] and fitted using the least squares method; the activation energy Ea of resistivity was 0.91 eV. In addition, the coefficient of determination R$^2$ of the approximation curve when exponential approximation was performed by the least squares method was 0.88. Here, A is a proportionality constant, k is the Boltzmann constant ($8.617 \times 10^{-5}$ eV/K), and T is temperature in Kelvin.

The results of the Hall measurements show that the c-plane GaN substrate, that is, the Ni-doped GaN layer, exhibited a large value of activation energy of resistivity. This large value possibly contributes to the large resistivity of the c-plane GaN substrate.

In addition, the type of carrier determined by the Hall measurements was p-type.

Measurement of Rocking Curve by X-Ray Diffraction

X-ray diffraction rocking curves (XRC) of (004) reflection and (201) reflection in the c-plane GaN substrate produced above were measured using an X-ray diffractometer [SmartLab available from Rigaku Corporation] using CuKα1 radiation as the X-ray source.

For the incident optical system of the X-ray diffractometer, a Ge (440) four-crystal monochromator was used. The size of the longitudinal limiting slit of the X-ray beam was set to 2 mm. The X-ray tube was operated at a voltage of 45 kV and a current of 40 mA.

The full width at half maximum (FWHM) of the rocking curve of the (004) reflection by X-ray diffraction was 16.3 arcsec. In addition, the full width at half maximum (FWHM) of the rocking curve of the (201) reflection by X-ray diffraction was 27.6 arcsec.

Example 2

A c-plane GaN substrate was produced in the same manner as in Example 1 except for changing the Ni concentration in the Ni-doped GaN layer to $3.0 \times 10^{17}$ atoms/cm$^3$. The Ni concentration of the c-plane GaN substrate produced above was measured by SIMS.

As a result, the Ni concentration in the c-plane GaN substrate was $3.0 \times 10^{17}$ atoms/cm$^3$. The C concentration was $2 \times 10^{16}$ atoms/cm$^3$. The Si concentration was $3 \times 10^{16}$ atoms/cm$^3$. The H concentration was $6 \times 10^{16}$ atoms/cm$^3$. The O concentration was $9 \times 10^{15}$ atoms/cm$^3$. That is, the Ni concentration in the Ni-doped GaN layer was $3.0 \times 10^{17}$ atoms/cm$^3$, the C concentration was $2 \times 10^{16}$ atoms/cm$^3$, the O concentration was $9 \times 10^{15}$ atoms/cm$^3$, the H concentration was $6 \times 10^{16}$ atoms/cm$^3$, the Si concentration was $3 \times 10^{16}$ atoms/cm$^3$, and the total donor impurity concentration was $3.9 \times 10^{16}$ atoms/cm$^3$.

The total thickness of the GaN crystal serving as the c-plane GaN substrate was 350 μm, and the GaN crystal was composed only of the Ni-doped GaN layer. That is, the thickness of the Ni-doped GaN layer was also 350 μm.

The resistivity and the carrier type were measured and the activation energy Ea of resistivity was also calculated in the same manner as in Example 1. The results are shown in FIG. 8.

In the graph of FIG. 8, 1000/T (1/K) was plotted on the x-axis, and the resistivity (Ω cm) was plotted on the y-axis. The resistivity was $3.63 \times 10^6$ Ω cm at 700 K and $8.43 \times 10^5$ Ω cm at 800 K; it decreased as the temperature was increased. The activation energy Ea of resistivity was 0.70 eV. In addition, the coefficient of determination $R^2$ of the approximation curve when exponential approximation was performed by the least squares method was 0.96.

The full width at half maximum (FWHM) of the rocking curve of the (004) reflection by X-ray diffraction was 18.0 arcsec. In addition, the full width at half maximum (FWHM) of the rocking curve of the (201) reflection by X-ray diffraction was 26.2 arcsec.

The present invention has been described in detail with reference to specific embodiments. However, it will be clear to those skilled in the art that various changes and modifications can be made without departing from the spirit and scope of the present invention. The present application is based on the Japanese Patent Application (JP 2023-130116) filed on August 9, 2023, the content of which is incorporated herein by reference.

Reference Signs List

[0209]

　1 Seed wafer
　2 GaN thick film
　3 c-plane GaN seed
　5 c-plane GaN seed
　6 GaN layer
　10 GaN crystal
　11 (0001) Surface
　20 HVPE apparatus
　21 Reactor
　22 Gallium reservoir

23 Susceptor
24 First heater
25 Second heater
100 GaN crystal
101 (0001) Surface
102 (000-1) Surface
110 First region
120 Second region

## Claims

1. A GaN crystal comprising a Ni-doped GaN layer, wherein
the Ni-doped GaN layer has a Ni concentration of $1.0 \times 10^{16}$ atoms/cm$^3$ or more and $1.0 \times 10^{20}$ atoms/cm$^3$ or less, and satisfies at least one of requirements (1) and (2) below:

   (1) the Ni-doped GaN layer has a total donor impurity concentration of less than $2.0 \times 10^{17}$ atoms/cm$^3$; and
   (2) the full width at half maximum of a rocking curve of the Ni-doped GaN layer by (004) X-ray diffraction is 50 arcsec or less.

2. The GaN crystal according to claim 1, wherein the Ni-doped GaN layer has a dislocation density of less than $1 \times 10^7$ cm$^{-2}$.

3. The GaN crystal according to claim 1 or 2, wherein an activation energy Ea of resistivity of the Ni-doped GaN layer is 0.5 eV or more, the activation energy Ea obtained by substituting the resistivity into Equation (I):

$$\text{Resistivity } (\Omega \text{ cm}) = A \times EXP(-Ea/kT) \text{ (I)}$$

   where

   A is a proportionality constant,
   EXP is an exponential function,
   Ea is the activation energy (eV) of resistivity,
   k is the Boltzmann constant ($8.617 \times 10^{-5}$ eV/K), and
   T is temperature (K) in Kelvin.

4. The GaN crystal according to claim 3, wherein the activation energy Ea of resistivity is from 0.7 to 1.2 eV.

5. The GaN crystal according to claim 3, wherein

   the activation energy Ea of resistivity is determined by a least squares method using the resistivity at two or more temperatures, and
   a coefficient of determination $R^2$ of an approximation curve when exponential approximation is performed by the least squares method is 0.85 or more.

6. The GaN crystal according to claim 3, wherein the activation energy Ea of resistivity is a value obtained by the least squares method by substituting the resistivity measured at 20 K intervals in a temperature range of 700 K to 800 K into Equation (I).

7. The GaN crystal according to claim 1 or 2, wherein both an oxygen (O) concentration and a silicon (Si) concentration in the Ni-doped GaN layer are $1.0 \times 10^{15}$ atoms/cm$^3$ or more.

8. The GaN crystal according to claim 1 or 2, wherein the resistivity of the Ni-doped GaN layer at 700 K is $5 \times 10^5$ $\Omega$ cm or more.

9. The GaN crystal according to claim 1 or 2, wherein the resistivity of the Ni-doped GaN layer at 800 K is $5 \times 10^4$ $\Omega$ cm or more.

**10.** The GaN crystal according to claim 1 or 2, wherein the Ni-doped GaN layer has a thickness of 50 $\mu$m or more.

**11.** The GaN crystal according to claim 1 or 2, wherein the Ni-doped GaN layer comprises a surface inclined at 10 degrees or less from the (0001) crystal plane.

**12.** A method for producing a GaN crystal comprising a Ni-doped GaN layer with a Ni concentration of $1.0 \times 10^{16}$ atoms/cm$^3$ or more and $1.0 \times 10^{20}$ atoms/cm$^3$ or less by a vapor phase epitaxy method, the method comprising: growing the Ni-doped GaN layer using nickel dichloride as a doping precursor.

**13.** The method for producing a GaN crystal according to claim 12, wherein the vapor phase epitaxy method is an HVPE method.

FIG. 1

FIG. 2

[0001]

$t_1$

[000-1]

100    101    110

102

# FIG. 3

FIG. 4

[0001]

(a)

[000-1]

1

[0001]

(b)

[000-1]

2

1

[0001]

(c)

[000-1]

3

3

3

1

# FIG. 5

FIG. 6

FIG. 7

FIG. 8

## INTERNATIONAL SEARCH REPORT

| International application No. |
|---|
| **PCT/JP2024/028245** |

**A. CLASSIFICATION OF SUBJECT MATTER**

*C30B 29/38*(2006.01)i; *C23C 16/34*(2006.01)i; *C30B 25/20*(2006.01)i; *H01L 21/205*(2006.01)i
FI: C30B29/38 D; C30B25/20; H01L21/205; C23C16/34

According to International Patent Classification (IPC) or to both national classification and IPC

**B. FIELDS SEARCHED**

Minimum documentation searched (classification system followed by classification symbols)

C30B29/38; C23C16/34; C30B25/20; H01L21/205

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JST7580/JSTChina (JDreamIII)

**C. DOCUMENTS CONSIDERED TO BE RELEVANT**

| Category* | Citation of document, with indication, where appropriate, of the relevant passages | Relevant to claim No. |
|---|---|---|
| X | WO 2020/171147 A1 (MITSUBISHI CHEMICAL CORPORATION) 27 August 2020 (2020-08-27)<br>claim 1, paragraph [0018] | 1, 2, 7, 10, 11 |
| A | JP 2007-534580 A (CREE, INC.) 29 November 2007 (2007-11-29)<br>claim 1 | 1-13 |
| A | JP 2013-058741 A (HITACHI CABLE, LTD.) 28 March 2013 (2013-03-28)<br>claims 1-9 | 1-13 |
| A | JP 2010-509178 A (MOMENTIVE PERFORMANCE MATERIALS INC.) 25 March 2010 (2010-03-25)<br>claims 1-40 | 1-13 |

☐ Further documents are listed in the continuation of Box C.　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **12 September 2024** | **24 September 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/028245**

| Patent document cited in search report | | | Publication date (day/month/year) | Patent family member(s) | | | Publication date (day/month/year) |
|---|---|---|---|---|---|---|---|
| WO | 2020/171147 | A1 | 27 August 2020 | US claim 1, paragraph [0087] CN | 2021/0384336 113454272 | A1 A | |
| JP | 2007-534580 | A | 29 November 2007 | US claim 1 CN | 2005/0009310 101297397 | A1 A | |
| JP | 2013-058741 | A | 28 March 2013 | US claims 1-9 CN | 2013/0043442 102956446 | A1 A | |
| JP | 2010-509178 | A | 25 March 2010 | US claims 1-40 CN | 2007/0158785 101583744 | A1 A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023130116 A

**Non-patent literature cited in the description**

- **M IWINSKA et al.** Iron and manganese as dopants used in the crystallization of highly resistive HVPE-GaN on native seeds. *Japanese Journal of Applied Physics*, 2019, vol. 58, SC1047